# EUROPÄISCHE PATENTSCHRIFT

(11) **EP 2 160 927 B1**
(45) Veröffentlichungstag und Bekanntmachung des Hinweises auf die Patenterteilung: **14.04.2021**
(21) Anmeldenummer: 08761220.6
(22) Anmeldetag: 19.06.2008
(51) Int. Cl.: H05B 45/37

(54) **SCHALTUNGSANORDNUNG UND VERFAHREN ZUR ANSTEUERUNG VON LICHTEMITTIERENDEN BAUELEMENTEN**
CIRCUIT ARRANGEMENT AND METHOD FOR CONTROLLING LIGHT-EMITTING COMPONENTS
CIRCUITERIE ET PROCÉDÉ POUR COMMANDER DES COMPOSANTS ÉLECTROLUMINESCENTS

(30) Priorität: 19.06.2007 DE 102007028576; 24.08.2007 DE 102007040151; 29.04.2008 DE 102008001453
(43) Veröffentlichungstag der Anmeldung: 10.03.2010
(73) Patentinhaber: Silicon Line GmbH, 80687 München (DE)
(72) Erfinder: GROEPL, Martin, 87527 Sonthofen (DE); HOELTKE, Holger, 80995 München (DE)
(74) Vertreter: Hofmann, Andreas
(86) Internationale Anmeldenummer: PCT/EP2008/057785
(87) Internationale Veröffentlichungsnummer: WO 2008/155385

(56) Entgegenhaltungen:
- EP-A- 0 798 828
- EP-A- 1 589 519
- EP-A- 1 816 723
- GB-A- 2 365 788
- US-A- 5 019 769
- US-A1- 2004 195 978
- US-A1- 2006 133 435

## Beschreibung

### Technisches Gebiet

Die vorliegende Erfindung betrifft allgemein das technische Gebiet der Ansteuerung von lichtemittierenden Bauelementen.

Die vorliegende Erfindung betrifft im Spezielleren eine Schaltungsanordnung, insbesondere Treiberschaltung, sowie ein Verfahren zum Ansteuern mindestens eines lichtemittierenden Bauelements *(vgl. Druckschrift* EP 0 798 828 A2 und auch Druckschrift US2006/133435 A1).

Im Rahmen der vorliegenden Erfindung wird unter dem Begriff Licht bzw. lichtemittierend nicht nur der für das Auge sichtbare Bereich der elektromagnetischen Strahlung verstanden, der sich in einem Wellenlängenbereich von etwa 380 Nanometer bis etwa 780 Nanometer erstreckt (, was einer Frequenz von etwa 789 Terahertz bis herab zu etwa 385 Terahertz entspricht).

Vielmehr wird unter dem Begriff Licht bzw. lichtemittierend das gesamte, also auch das für das Auge nicht sichtbare elektromagnetische Wellenlängen- bzw. Frequenzspektrum verstanden, insbesondere der I[nfra]R[ot]-Bereich (Wellenlängenbereich bis zu etwa 2.000 Nanometer bzw. Frequenzbereich bis herab zu etwa 150 Terahertz), zum Beispiel eine Wellenlänge von etwa 850 Nanometer bzw. eine Frequenz von etwa 350 Terahertz.

### Stand der Technik

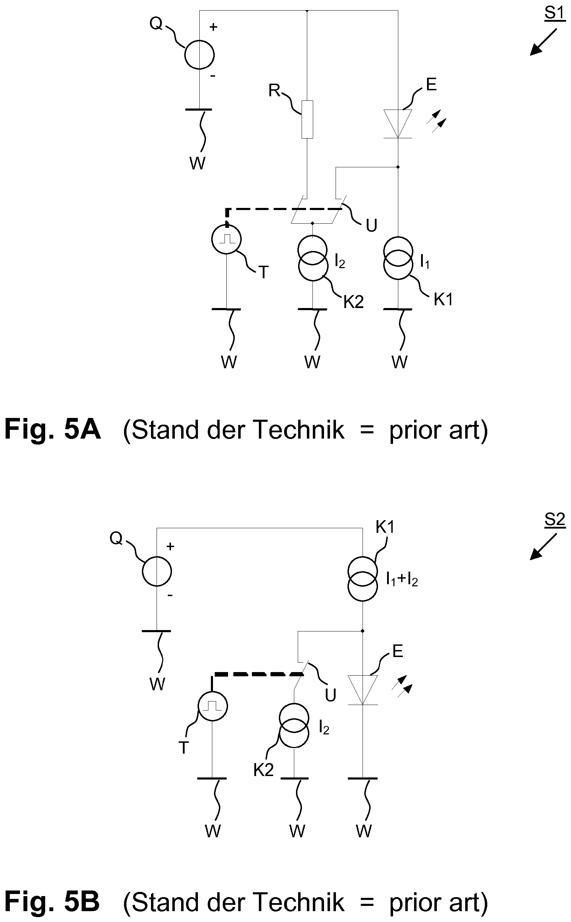

Aus dem Stand der Technik bekannte exemplarische Schaltungsanordnungen zur Ansteuerung eines lichtemittierenden Bauelements E zum Zwecke der Datenübertragung vom lichtemittierenden Bauelement E (= sogenannte Quelle) zu einem lichtempfangenden Bauelement (= sogenannte Senke) sind in Fig. 5A bis Fig. 5C dargestellt.

Typischerweise wird zur optischen Datenübertragung als lichtemittierendes Bauelement E, insbesondere als optisches Sendeelement oder als optische Quelle, ein Halbleiterlaser oder eine Leuchtdiode benutzt.

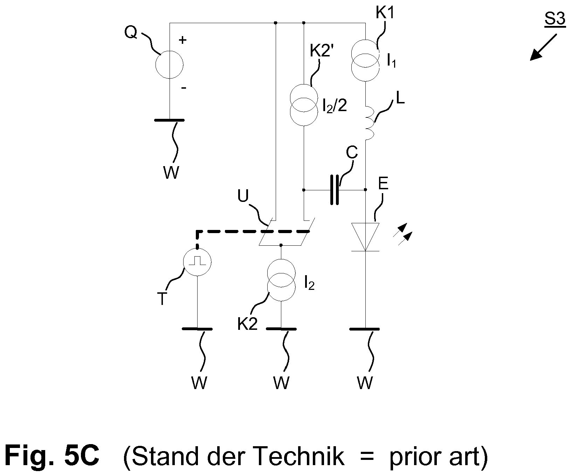

Dieser Halbleiterlaser oder diese Leuchtdiode wird gemäß dem Stand der Technik beispielsweise von einer elektronischen Treiberschaltung S1 (vgl. Fig. 5A), S2 (vgl. Fig. 5B) oder S3 (vgl. Fig. 5C) mit der notwendigen Betriebsspannung, dem Vorstrom (Bias-Strom) und dem Modulationsstrom für den korrekten Betrieb versorgt.

Die Treiberschaltung S1, S2, S3 kann sowohl als eine integrierte Schaltung (oder IC = Integrated Circuit) als auch diskret aus einzelnen Komponenten auf einer Leiterplatte (oder PCB = Printed Circuit Board) aufgebaut sein.

Beim in Fig. 5A gezeigten Beispiel aus dem Stand der Technik kann das lichtemittierende Bauelement E über einen ersten Strompfad I₁ und zusätzlich über einen zweiten Strompfad I₂ mit Strom versorgt werden. Hierzu fließt im ersten Strompfad der Strom I₁ von einer Gleichspannungsquelle Q über das lichtemittierende Bauelement E zu einer Konstantstromquelle K1 für I₁.

Durch Aktivschalten oder Zuschalten des zweiten Strompfads I₂ mittels eines den Strompegel des lichtemittierenden Bauelements E steuernden Umschalters U fließt durch das lichtemittierende Bauelement E der Gesamtstrom I_{ges} = I₁ + I₂, ansonsten der Strom I₁. Zur Stromversorgung des zweiten Strompfads I₂ ist eine Konstantstromquelle K2 vorgesehen.

Die Modulation des lichtemittierenden Bauelements E erfolgt also in Form von Stromeinstellung oder Strommodulation, das heißt durch zeitliches Variieren der durch das lichtemittierende Bauelement E fließenden Stromstärken zwischen den Werten I₁ und I₁ + I₂.

Die Anordnung von Umschalter U und Blindlast R bewirkt, dass am dem Umschalter U in Bezug auf den zweiten Strompfad I₂ zugeordneten Knotenpunkt stets der gleiche Strom fließt, wobei der Strom I₂ in dem Falle, dass der zweite Strompfad I₂ nicht dem lichtemittierenden Bauelement E zugeschaltet ist, in der Blindlast R im Wesentlichen in thermische Energie umgewandelt wird, was beispielsweise zu etwa fünfzig Prozent der Betriebszeit des lichtemittierenden Bauelements der Fall sein kann; allerdings ist der Strom I₂ unvorteilhafterweise auch dann vorhanden, wenn dieser Strom I₂ gar nicht benötigt wird.

Des Weiteren sind beim in Fig. 5A gezeigten Beispiel aus dem Stand der Technik die beiden Konstantstromquellen K1 und K2 im Hochfrequenzpfad angeordnet, was notwendigerweise parasitäre Kapazitäten nach sich zieht. Auch treten beim in Fig. 5A gezeigten Beispiel aus dem Stand der Technik notwendigerweise ein unerwünschter hoher Spannungsabfall bzw. eine hohe Sättigungsspannung auf.

Bei der in Fig. 5B dargestellten zweiten exemplarischen Treiberschaltung S2 gemäß dem Stand der Technik fließt bei Aktivschalten oder Zuschalten des zweiten Strompfads I₂ mittels des den Strompegels steuernden Einschalters U durch das lichtemittierende Bauelement E der Strom I₁ + I₂, ansonsten der Strom I₁; allerdings ist der Strom I₂ unvorteilhafterweise auch dann vorhanden, wenn dieser Strom I₂ gar nicht benötigt wird.

Die Betriebsspannung des lichtemittierenden Bauelements E hängt von der durch die Spannungsquelle Q zur Verfügung gestellten Versorgungsspannung (= zum Beispiel etwa drei Volt) und von der Konstantstromquelle K1 bzw. von den Konstantstromquellen K1, K2 ab.

Bei der in Fig. 5C dargestellten dritten exemplarischen Treiberschaltung S3 gemäß dem Stand der Technik fließt in Abhängigkeit von der Stellung des den Strompegel steuernden Umschalters U durch das lichtemittierende Bauelement E der Strom I₁ + 0,5·I₂ oder der Strom I₁ - 0,5·I₂, das heißt auch hier beträgt die Stromdifferenz I₂.

Die Anordnung einer (nicht obligatorischen) Spule L, an der beispielsweise eine Spannung von etwa 0,5 Volt abfällt, dient üblicherweise der Impedanzerhöhung der Konstantstromquelle K1 bei hohen Frequenzen und ermöglicht demzufolge den Einsatz einer Konstantstromquelle K1, die keine hohe Ausgangsimpedanz bei hohen Frequenzen aufweist.

Neben der vorbeschriebenen Treiberschaltung S3 ist auch aus der Druckschrift US 6 667 661 B1 aus dem Stand der Technik eine Treiberschaltung mit Spule bekannt.

Unvorteilhafterweise erforderlich ist bei der in Fig. 5C dargestellten elektronischen Treiberschaltung S3 jedoch die Anordnung externer, das heißt außerhalb der integrierten Schaltung angeordneter Bauelemente, wie etwa eines Kondensators C.

Aufgrund der Anordnung aus Spule L und Kondensator C können des Weiteren unerwünschte elektromagnetische Störeffekte, wie etwa elektromagnetische Schwingungen, auftreten. Mit dem Problem der Vermeidung elektromagnetischer Schwingungen einer Lasertreiberschaltung mit signalverstärkter Datenübertragung befasst sich in diesem Zusammenhang beispielsweise die Druckschrift US 7 133 429 B2 aus dem Stand der Technik.

Ein weiterer Nachteil konventioneller Schaltungsanordnungen ist deren hoher Spannungsabfall an den, zum lichtemittierenden Bauelement in Reihe liegenden, Bauelementen. Insbesondere für Anwendungen bei denen nur eine kleine Versorgungsspannung zur Verfügung steht, steht dieses im Widerspruch zum Ziel, am lichtemittierenden Bauelement eine möglichst hohe Betriebsspannung bereit zu stellen.

Die technische Problemstellung, eine Treiberschaltung zur optischen Datenübertragung mit geringem Leistungsbedarf bereit zu stellen, ist beispielsweise aus den Druckschriften US 6 965 722 B1 sowie US 7 154 923 B2 aus dem Stand der Technik bekannt. Der Aufbau der in diesen Druckschriften beschriebenen Treiberschaltungen ist jedoch sehr komplex.

Zudem haben aus dem Stand der Technik bekannte Schaltungsanordnungen nachteiligerweise hohe Ausgangswiderstände (= Realteile der Ausgangsimpedanzen). Dies begrenzt die Geschwindigkeit, insbesondere für das Einschwingen (oder Settling) der Schaltungsanordnung, denn die maximale Schaltfrequenz f verhält sich im Wesentlichen reziprok proportional zum Produkt aus Gesamtkapazität C und Gesamtwiderstand R am Ausgang der Ansteuer- oder Treiberschaltung, wobei
- die Gesamtkapazität C zum Beispiel im Wesentlichen durch die parasitäre kapazitive Wirkung des lichtemittierenden Bauelements dominiert ist und
- der Gesamtwiderstand R im Wesentlichen durch die Parallelschaltung des Ausgangswiderstands der Treiberschaltung und des Eingangswiderstands des lichtemittierenden Bauelements gegeben ist.

Schließlich ist ein weiteres technisches Problem konventioneller Schaltungsanordnungen eine (zu) niedrige Ausgangsspannung am lichtemittierenden Bauelement, denn die Konstantstromquelle(n) benötigt/en eine(n) Spannung(sabfall) von beispielsweise etwa 0,5 Volt (ein geringer Spannungsabfall in Höhe von beispielsweise etwa 0,2 Volt erfolgt auch an der die Versorgungsspannung zur Verfügung stellenden Spannungsquelle, sofern es sich um eine geregelte Spannungsquelle handelt).

Ein weiterer geringer Spannungsabfall in Höhe von beispielsweise etwa 0,1 Volt erfolgt am Schaltelement U, so dass am lichtemittierenden Bauelement (zu) wenig Spannung abfällt und damit am lichtemittierenden Bauelement (zu) wenig Spannung zur Verfügung steht.

### Darstellung der vorliegenden Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Schaltungsanordnung der eingangs genannten Art sowie ein Verfahren der eingangs genannten Art so weiterzuentwickeln, dass die vorstehend dargelegten Nachteile und Unzulänglichkeiten vermieden werden; insbesondere sollen Strombedarf und Ausgangswiderstand möglichst niedrig sein, so dass eine möglichst hohe Frequenz oder Schaltgeschwindigkeit sowie eine möglichst hohe Ausgangsspannung für das lichtemittierende Bauelement erzielt werden können.

Diese Aufgabe wird durch eine Schaltungsanordnung mit den im Anspruch 1 angegebenen Merkmalen sowie durch ein Verfahren mit den im Anspruch 5 angegebenen Merkmalen sowie durch eine Verwendung einer Schaltungsanordnung nach Anspruch 1 mit den in Anspruch 7 angegebenen Merkmalen gelöst.

Das lichtemittierende Bauelement wird
- in der ersten Schaltposition des Schaltelements mit einer ersten Betriebsspannung beaufschlagt,
- in der zweiten Schaltposition des Schaltelements mit einer zweiten Betriebsspannung beaufschlagt und
- durch Umschalten zwischen der ersten Betriebsspannung und der zweiten Betriebsspannung angesteuert; insbesondere wird das lichtemittierende Bauelement durch Umschalten zwischen den Schaltpositionen angesteuert, von denen zumindest die erste Schaltposition des Schaltelements und die zweite Schaltposition des Schaltelements für die Betriebsfrequenz niederimpedant sind.

Das Schaltelement ist zweckmäßigerweise als mindestens ein Einschalter oder als mindestens ein Umschalter oder als mindestens ein Wechselschalter, zum Beispiel als mindestens ein Schalttransistor, wie etwa als mindestens ein M[etal]O[xide]S[emiconductor]F[ield]E[ffect]T[ransistor], ausgebildet. Auf diese Weise sind mindestens zwei Betriebszustände der Schaltungsanordnung mit jeweils niedrigen Impedanzen, insbesondere ohne weitere Stromverluste, erzielbar.

Ein Versorgungselement im Sinne der vorliegenden Erfindung kann beispielsweise als mindestens eine Spannungsquelle oder als Kombination aus Stromquelle und Stützkondensator realisiert sein, so dass für die relevanten Betriebsfrequenzen eine niedrige Ausgangsimpedanz entsteht.

Das lichtemittierende Bauelement ist somit durch Variieren seiner Betriebsspannung mittels Umschaltens der auf das lichtemittierende Bauelement beaufschlagten Spannung, insbesondere der in das lichtemittierende Bauelement eingeprägten Spannung, ansteuerbar und kann beispielsweise zur optischen Datenübertragung dienen. Hierzu wandelt das lichtemittierende Bauelement elektrische Signale in optische Signale um, die in einen Lichtwellenleiter, beispielsweise in eine Glasfaser oder in eine Kunststofffaser, eingekoppelt werden.

Bei der vorliegenden Erfindung wird das lichtemittierende Bauelement somit spannungsgesteuert ("voltage-driven") in mindestens zwei Arbeitspunkten betrieben, die mittels des Schaltelements sowie optionalerweise mittels mindestens einer Steuerungseinrichtung, insbesondere Signalquelle, zum Steuern des Schaltelements konfigurierbar sind.

Die erfindungsgemäße Schaltungsanordnung ist aufgrund ihres niedrigen Strombedarfs besonders vorteilhaft. Der Strombedarf ist besonders niedrig, weil es - im Unterschied zum Stand der Technik - außerhalb des lichtemittierenden Bauelements keinen weiteren Strompfad gibt.

Des Weiteren wird der Fachmann bei der vorliegenden Erfindung die vergleichsweise hohe, für das lichtemittierende Bauelement zur Verfügung stehende Ausgangsspannung besonders zu schätzen wissen.

Ferner ist die niedrige Ausgangsimpedanz ein weiterer Vorteil der vorliegenden Erfindung. Dies ermöglicht eine hohe Geschwindigkeit, insbesondere für das Einschwingen der Schaltungsanordnung, denn die maximale Schaltfrequenz f verhält sich im Wesentlichen reziprok proportional zum Produkt aus Gesamtkapazität C und Gesamtwiderstand R am Ausgang der Ansteuer- oder Treiberschaltung, wobei
- die Gesamtkapazität C zum Beispiel im Wesentlichen durch die parasitäre kapazitive Wirkung des lichtemittierenden Bauelements dominiert ist und
- der Gesamtwiderstand R im Wesentlichen durch die Parallelschaltung des Ausgangswiderstands der Treiberschaltung und des Eingangswiderstands des lichtemittierenden Bauelements gegeben ist.

Beim lichtemittierenden Bauelement *handelt* es sich um eine lichtemittierende Diode (= L[ight]E[mitting]D[iode]), wie etwa um eine Leuchtdiode, oder etwa um einen Halbleiterlaser.

Das Ansteuern des lichtemittierenden Bauelements erfolgt zum Beispiel zum Zwecke der Datenübertragung von mindestens einem lichtemittierenden Bauelement (= sogenannte Quelle) zu mindestens einem lichtempfangenden Bauelement (= sogenannte Senke).

Die Datenübertragung kann zum Beispiel über mindestens ein Trägermedium, wie etwa über Glasfaser oder über Kunststofffaser, oder auch über Luft als Trägermedium oder durch Vakuum erfolgen.

Die vorliegende Erfindung betrifft schließlich die Verwendung mindestens einer Schaltungsanordnung, insbesondere mindestens einer Treiberschaltung, gemäß der vorstehend dargelegten Art und/oder eines Verfahrens gemäß der vorstehend dargelegten Art
- in mindestens einer, insbesondere mobilen, Telekommunikationsanlage, zum Beispiel in mindestens einem Kommunikationsgerät, wie etwa in mindestens einem Mobiltelefon,
- in mindestens einer, insbesondere mobilen, Datenkommunikationsanlage oder in mindestens einer, insbesondere mobilen, Datenverarbeitungseinrichtung, zum Beispiel in mindestens einem Handheld, in mindestens einem Notebook oder in mindestens einem P[ersonal]D[igital]A[ssistant],
- in mindestens einer, insbesondere mobilen, Datenaufzeichnungs- und/oder -wiedergabeeinrichtung, zum Beispiel in mindestens einem Camcorder, in mindestens einer Digitalkamera oder in mindestens einem H[igh]D[efinition]T[ele]V[ision], oder
- in mindestens einem Fortbewegungsmittel, zum Beispiel in mindestens einem Fahrerassistenzsystem oder in mindestens einem Navigationssystem eines Automobils.

In einem mobilen Kommunikationsgerät oder in einer mobilen Datenverarbeitungseinrichtung ist die vorliegende Erfindung besonders vorteilhaft einsetzbar, denn bei diesen Anwendungsgebieten ist die durch die Batterie bzw. durch die Akkumulatoreneinheit, umgangssprachlich auch Akku, zur Verfügung gestellte Versorgungsspannung begrenzt; im Sinne einer möglichst langen Betriebszeit des Akkus ist ein durch die vorliegende Erfindung ermöglichter effizienter Umgang mit der Versorgungsspannung und der Leistungsaufnahme von besonderem Nutzen.

Im Ergebnis können durch das Ansteuern des lichtemittierenden Bauelements mittels Umschaltens seiner Betriebsspannung, also durch den vorliegenden spannungsgetriebenen ("voltage-driven") Ansatz gemäß der vorliegenden Erfindung eine sehr niedrige Ausgangsimpedanz und damit eine sehr hohe Frequenz oder Schaltgeschwindigkeit erzielt werden.

Der Fachmann auf dem technischen Gebiet der Ansteuerung von lichtemittierenden Bauelementen wird insbesondere zu schätzen wissen, dass die Schaltungsanordnung gemäß der vorliegenden Erfindung wie auch das Verfahren gemäß der vorliegenden Erfindung sowohl eine niedrige Ausgangsimpedanz als auch einen geringen Energiebedarf aufweisen.

### Kurze Beschreibung der Zeichnungen

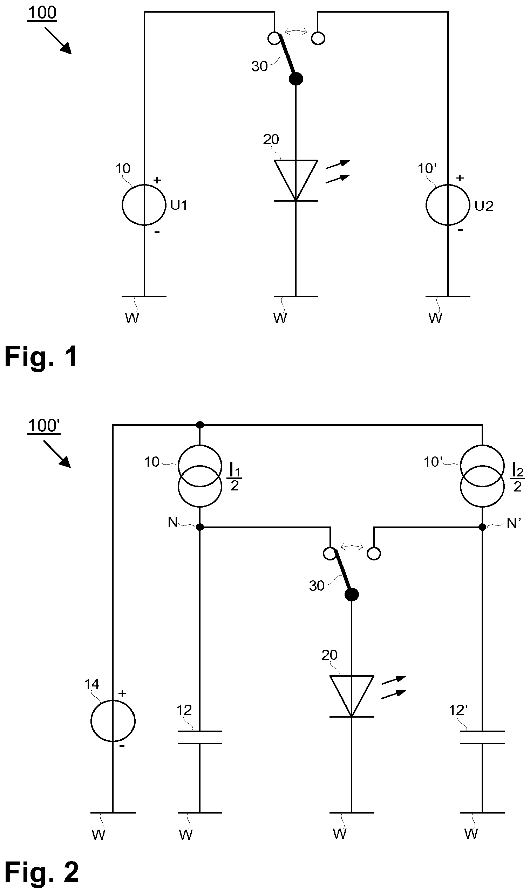

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 sowie dem Anspruch 5 nachgeordneten Ansprüche verwiesen, andererseits werden weitere Ausgestaltungen, Merkmale und Vorteile der vorliegenden Erfindung nachstehend unter Anderem anhand der durch Fig. 1 bis Fig. 4C veranschaulichten Ausführungsbeispiele näher erläutert.

Es zeigt:
- Fig. 1: in schematischer Darstellung ein erstes, *jedoch nicht unter die vorliegende Erfindung fallendes* Ausführungsbeispiel einer Schaltungsanordnung
- Fig. 2: in schematischer Darstellung ein zweites Ausführungsbeispiel einer Schaltungsanordnung ;
- Fig. 3: in schematischer Darstellung ein drittes Ausführungsbeispiel einer Schaltungsanordnung ;
- Fig. 4A: in schematischer Darstellung ein viertes Ausführungsbeispiel einer Schaltungsanordnung ;
- Fig. 4B: in diagrammatischer Darstellung die gegen die Gate-Source-Spannung aufgetragene DrainstromKennlinie für den in der Schaltungsanordnung aus Fig. 4A enthaltenen Transistor;
- Fig. 4C: in schematischer Detaildarstellung gemäß der vorliegenden Erfindung, die nach dem Verfahren der vorliegenden Erfindung arbeitet, eine zwei Transistoren aufweisende Variante der Schaltungsanordnung aus Fig. 4A;
- Fig. 5A: in schematischer Darstellung ein erstes Ausführungsbeispiel einer Schaltungsanordnung gemäß dem Stand der Technik;
- Fig. 5B: in schematischer Darstellung ein zweites Ausführungsbeispiel einer Schaltungsanordnung gemäß dem Stand der Technik; und
- Fig. 5C: in schematischer Darstellung ein drittes Ausführungsbeispiel einer Schaltungsanordnung gemäß dem Stand der Technik.

Gleiche oder ähnliche Ausgestaltungen, Elemente oder Merkmale sind in Fig. 1 bis Fig. 5C mit identischen Bezugszeichen versehen.

### Bester Weg zur Ausführung der vorliegenden Erfindung

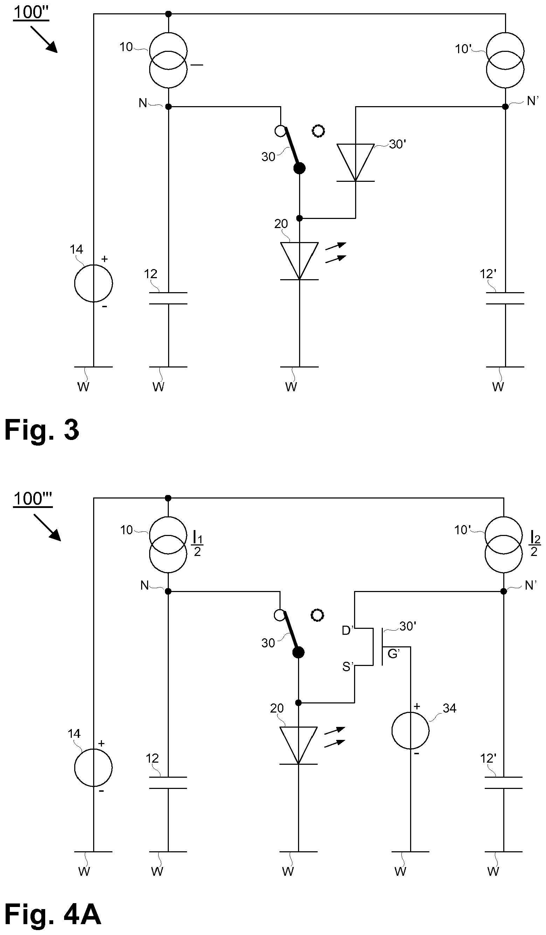

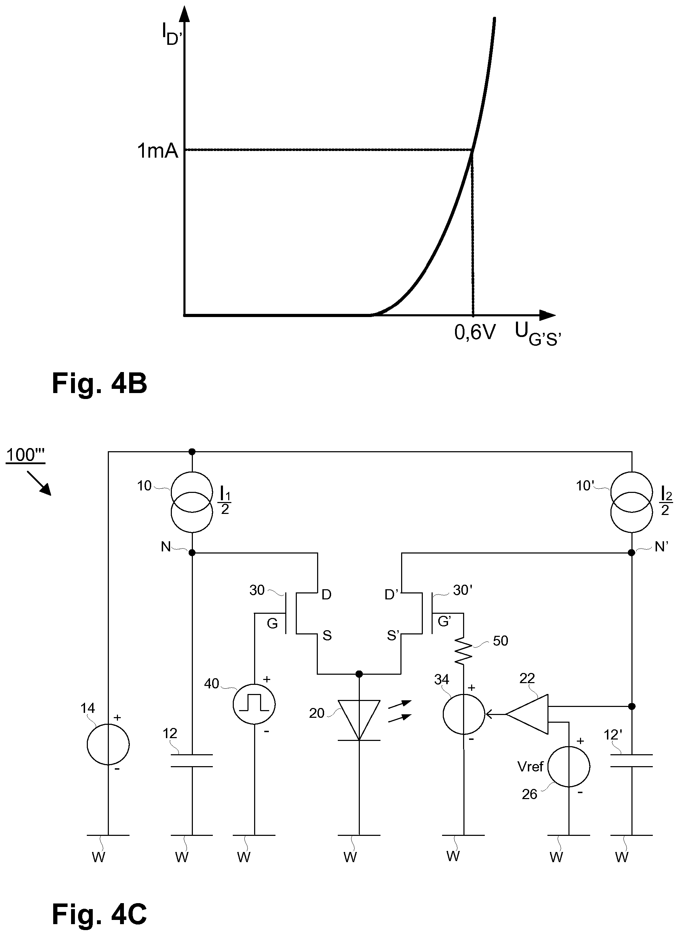

Zur Vermeidung überflüssiger Wiederholungen beziehen sich die nachfolgenden Erläuterungen hinsichtlich der Ausgestaltungen, Merkmale und Vorteile der vorliegenden Erfindung - soweit nicht anderweitig angegeben -
- sowohl auf das in Fig. 1 dargestellte erste Ausführungsbeispiel einer Schaltungsanordnung 100
- als auch auf das in Fig. 2 dargestellte zweite Ausführungsbeispiel einer Schaltungsanordnung 100'
- als auch auf das in Fig. 3 dargestellte dritte Ausführungsbeispiel einer Schaltungsanordnung 100"
- als auch auf das in Fig. 4A, in Fig. 4B, in Fig. 4C dargestellte vierte Ausführungsbeispiel einer Schaltungsanordnung 100"

Ein Ausführungsbeispiel der Erfindung ist in Figur 4C angegeben.

In Figur 1 ist ein Ausführungsbeispiel einer Schaltungsanordnung 100, nämlich eine Ansteuerschaltung oder Treiberschaltung, zum Ansteuern eines lichtemittierenden Bauelements 20, beispielsweise einer lichtemittierenden Diode (= L[ight]E[mitting]D[iode]) oder Leuchtdiode oder eines Lasers, zum Beispiel eines Halbleiterlasers, gezeigt.

Diese Schaltung 100 weist neben dem lichtemittierenden Bauelement 20 zwei gegen ein Bezugspotential oder Referenzpotential W, insbesondere gegen Erdpotential oder Massepotential oder Nullpotential, betriebene Versorgungselemente in Form von Spannungsquellen 10 bzw. 10' (Akkumulatoreinheit) zur Versorgung der Schaltungsanordnung 100 mit erster Betriebsspannung U₁ bzw. mit zweiter Betriebsspannung U₂ auf.

Wie in Fig. 1 dargestellt, ist der Schaltungsanordnung 100 ferner ein Schaltelement 30, insbesondere ein Umschalter oder Wechselschalter, zum Beispiel für jede Schaltposition jeweils ein Schalttransistor, wie etwa jeweils ein M[etal]O[xide]S[emiconductor]-F[ield]E[ffect]T[ransistor], zugeordnet.

Dieses Schaltelement 30 ist zum Ansteuern des lichtemittierenden Bauelements 20 mittels Schaltens zumindest zwischen einer ersten Schaltposition und einer zweiten Schaltposition ausgebildet.

Hierbei fällt in der ersten Schaltposition des Schaltelements 30 die gesamte oder nahezu die gesamte von der ersten Spannungsquelle 10 bereit gestellte Spannung U₁ am lichtemittierenden Bauelement 20 ab; exemplarisch können in der ersten Schaltposition des Schaltelements 30 mindestens etwa neunzig Prozent, zum Beispiel etwa 99 Prozent, der von der ersten Spannungsquelle 10 bereit gestellten Spannung am lichtemittierenden Bauelement 20 abfallen.

Hingegen fällt in der zweiten Schaltposition des Schaltelements 30 die gesamte oder nahezu die gesamte von der zweiten Spannungsquelle 10' bereit gestellte Spannung U₂ am lichtemittierenden Bauelement 20 ab; exemplarisch können in der zweiten Schaltposition des Schaltelements 30 mindestens etwa neunzig Prozent, zum Beispiel etwa 99 Prozent, der von der zweiten Spannungsquelle 10' bereit gestellten Spannung am lichtemittierenden Bauelement 20 abfallen.

Die Schaltungsanordnung 100' gemäß dem anhand Fig. 2 veranschaulichten zweiten Ausführungsbeispiel weist als Versorgungselemente zwei parallel zueinander geschaltete Stromquellen 10 bzw. 10' auf, deren Ausgänge jeweils mittels eines Stützkondensators 12 bzw. 12' kapazitiv gestützt sind.

Zur Versorgung mit Versorgungsspannung 14 (sogenannte Urspannung), zum Beispiel in der Größenordnung von etwa drei Volt, weist die Schaltungsanordnung 100' ein Versorgungselement in Form einer Batterie auf.

Wie also in Fig. 2 dargestellt, kann das Versorgungselement auch als ausgangsseitig kapazitiv gestützte Stromquelle, etwa als Kombination oder Zusammenschaltung aus für Anwendungen bei niedrigen Frequenzen optimierter Stromquelle 10, 10' und Stützkondensator 12, 12', ausgebildet sein.

Die Stromquelle 10 bzw. 10' dient hierbei zur bedarfsgemäßen Stromnachführung. Der Stützkondensator 12 bzw. 12' dient dazu, die Impedanz des Knotens N bzw. N' für den Bereich der Schalt- und Betriebsfrequenzen der Treiberschaltung 100' zu verringern.

Da sich eine Erhöhung der Kapazität am Knotenpunkt N bzw. N' vorteilhaft auf die Stützwirkung an diesem Knotenpunkt N bzw. N' auswirkt, ist bei der Dimensionierung der Stromquelle 10 bzw. 10' keine Obergrenze für deren parasitäre Ausgangskapazität zu beachten, denn die Ausgestaltung gemäß Fig. 2 ist gegen parasitäre Kapazitäten unempfindlich.

Hierdurch kann die Stromquelle 10 bzw. 10' so dimensioniert werden, dass sie auch bei sehr geringer Spannungsdifferenz zwischen der Versorgungsspannung 14 und der Spannung am Knotenpunkt N bzw. N' bestimmungsgemäß arbeitet.

In der ersten Schaltposition des Schaltelements 30 wird das lichtemittierende Bauelement 20 mit dem Knotenpunkt N verbunden, an dem eine exemplarische Spannung von etwa 2,8 Volt anliegt. In der zweiten Schaltposition des Schaltelements 30 wird das lichtemittierende Bauelement 20 mit dem Knotenpunkt N' verbunden, an dem eine exemplarische Spannung von etwa 2,3 Volt anliegt.

Hierbei ist der den Ausgang der Stromquelle 10 bzw. 10' und die erste bzw. zweite Schaltposition des Schaltelements 30 verknüpfende Knotenpunkt N bzw. N' durch den Stützkondensator 12 bzw. 12' hochkapazitiv gestützt sowie mit dem zu übertragenden Signal im Wesentlichen "nicht bewegt", das heißt konstant.

Unter Berücksichtigung eines exemplarischen Spannungsverlustes am Schaltelement 30 in Höhe von beispielsweise etwa 0,1 Volt werden auf diese Weise beim lichtemittierenden Bauelement 20 hochfrequent zwischen etwa 2,7 Volt und etwa 2,2 Volt wechselnde Signale ermöglicht, denn durch die kapazitive Stützung der Knoten N bzw. N' wird "beidseitig" eine Abgrenzung oder Trennung zwischen dem niederfrequenten Zweig der Stromquelle 10, 10' und dem hochfrequenten Zweig des lichtemittierenden Bauelements 20 herbei geführt.

Hierbei wirkt sich in vorteilhafter Weise aus, dass der niederkapazitive und kleinflächige Umschalter 30 so gut wie keinen kapazitiven Beitrag leistet und ein hochfrequentes, das heißt sehr schnelles Schalten zwischen den beiden im Wesentlichen statischen Zuständen ermöglicht.

Im Ergebnis ermöglicht die Schaltungsanordnung 100' gemäß dem anhand Fig. 2 veranschaulichten zweiten Ausführungsbeispiel eine besonders effektive Nutzung der Versorgungsspannung 14 sowie die Möglichkeit der Modifikation für die durch die Stromquellen 10 bzw. 10' zur Verfügung gestellten Stromstärken 0,5·I₁ bzw. 0,5·I₂ (--> Schalten zwischen der Stromstärke I₁ am lichtemittierenden Bauelement 20 in der ersten Schaltposition und der Stromstärke I₂ am lichtemittierenden Bauelement 20 in der zweiten Schaltposition, sofern eine im zeitlichen Mittel gleichverteilte Aktivierung beider Schaltpositionen vorliegt).

Auch kann bei der Treiberschaltung 100' die Ausgangsimpedanz bei hohen Frequenzen sehr niedrig gehalten werden, denn diese Ausgangsimpedanz ist lediglich durch den parasitären Widerstand des Schaltelements 30 limitiert, so dass eine sehr hohe Betriebsfrequenz oder Schaltgeschwindigkeit erzielt werden kann.

Im besonderen Fall der vorliegenden Erfindung kann eine sehr hohe Ausgangsspannung für das lichtemittierende Bauelement 20 erzielt werden, denn über den Schalter 30 erfolgt nur ein sehr geringer Spannungsabfall; zudem ist die Stromquelle 10, 10' vorteilhafterweise im Versorgungspfad und nicht im hochfrequenten Signalpfad angeordnet.

Bei der Schaltungsanordnung 100" gemäß dem anhand Fig. 3 veranschaulichten dritten Ausführungsbeispiel einer Schaltungsanordnung ist zwischen den zweiten Knotenpunkt N' und die zweite Schaltposition des Schaltelements 30 eine in Vorwärtsrichtung, insbesondere zur zweiten Schaltposition des Schaltelements 30 hin, gepolte Diode 30', zum Beispiel eine pn-Diode oder eine Schottky-Diode, geschaltet. Diese Diode 30' leitet in Vorwärtsrichtung, das heißt zum Schaltelement 30 hin, und sperrt in Rückwärtsrichtung. Durch den Einsatz einer derartigen, zwischen den Knoten N' und den Eingang des lichtemittierenden Bauelements 20 geschalteten Diode 30' als zweite Komponente des Schaltelements 30 wird insofern eine Vereinfachung desselben erreicht, als nur ein Schaltelement angesteuert wird und demzufolge nur ein Ansteuersignal existiert.

Die Diode 30' übernimmt hierbei die Funktion der zweiten (, in Fig. 3 rechten) Schaltstellung, nämlich jeweils dann zu leiten, wenn der erste (, in Fig. 3 linke) Strompfad des Schalters 30 ausgeschaltet ist.

Eine eventuell nicht vernachlässigbare Durchlassspannung der in Vorwärtsrichtung gepolten Diode 30', zum Beispiel in der Größenordnung von etwa 0,2 Volt im Falle einer Schottky-Diode, führt zu einem entsprechend großen Spannungsverlust zwischen der Spannung am Knotenpunkt N' und der dem lichtemittierenden Bauelement 20 zur Verfügung stehenden Betriebsspannung.

Da dieser Spannungsverlust aber nur bei derjenigen Schaltposition auftritt, der beabsichtigterweise eine verringerte Betriebsspannung am lichtemittierenden Bauelement 20 zugeordnet ist, kann eine Kompensation des Spannungsverlusts durch Anheben der Spannung am Knotenpunkt N' erfolgen.

Bei der Schaltungsanordnung 100'" gemäß dem anhand Fig. 4A veranschaulichten vierten Ausführungsbeispiel einer Schaltungsanordnung ist zwischen den zweiten Knotenpunkt N' und die zweite Schaltposition des Schaltelements 30 ein n-Kanal-M[etal]O[xide]S[emiconductor]F[ield]E[ffect]T[ransistor] 30' geschaltet,
- dessen Drainanschluss D' mit dem zweiten Knotenpunkt N',
- dessen Gateanschluss G' mit einem Stützversorgungselement 34, insbesondere mit einer Stützspannungsquelle (zum Beispiel etwa 2,8 Volt), und
- dessen Sourceanschluss S' mit dem Eingangsanschluss des lichtemittierenden Bauelements 20 verbunden ist.

Die Kennlinie für den Drainstrom I_{D'} dieses n-Kanal-MOSFET 30' ist in Fig. 4B gegen die Gate-Source-Spannung U_{G'S'} dieses n-Kanal-MOSFET 30' (= von Gate G' des n-Kanal-MOSFET 30' nach Source S' des n-Kanal-MOSFET 30' gemessene Spannung) aufgetragen, wobei die der zweiten Schaltposition zugeordnete Stromstärke I₂ mit einer exemplarischen Größenordnung von etwa einem Milliampere bei einer Gate-Source-Spannung U_{G'S'} von beispielsweise etwa 0,6 Volt auftritt.

In einer zu Fig. 4A alternativen, anhand Fig. 4C veranschaulichten Ausgestaltung der Schaltungsanordnung 100'" gemäß der vorliegenden Erfindung ist das Schaltelement als zwei n-Kanal-M[etal]O[xide]S[emiconductor]F[ield]E[ffect]T[ransistor]s 30 bzw. 30' ausgebildet,
- deren jeweilige Drainanschlüsse D bzw. D' über den Knoten N bzw. N' mit der ersten Stromquelle 10 bzw. mit der zweiten Stromquelle 10' verbunden sind,
- deren Gateanschluss G mit einer Steuerungseinrichtung 40, zum Beispiel in Form einer Signalquelle, bzw. deren Gateanschluss G' über ein optionales Widerstandselement 50 mit einer Stützspannungsquelle oder mit einem Stützversorgungselement 34 verbunden ist und
- deren jeweilige Sourceanschlüsse S bzw. S' miteinander sowie mit dem Eingangsanschluss des lichtemittierenden Bauelements 20 verbunden sind.

Hierbei ist bei der anhand Fig. 4C veranschaulichten Variante der Schaltungsanordnung 100'" gemäß der vorliegenden Erfindung ein Regelungs-/Verarbeitungselement 22 in Form eines Komparators oder in Form eines Verstärkers vorgesehen,
- dessen erster Eingangsanschluss mit der zweiten kapazitiv gestützten Stromquelle 10' verbunden ist,
- dessen optionaler zweiter Eingangsanschluss mit einer optionalen Referenzspannungsquelle 26 verbunden ist und
- dessen Ausgangsanschluss mit dem Stützversorgungselement 34 verbunden ist.

Ein derartiges Regelungs-/Verarbeitungselement 22 kann - obwohl in Fig. 4A nicht explizit dargestellt - auch bei der Schaltungsanordnung 100'" gemäß dem anhand Fig. 4A veranschaulichten vierten Ausführungsbeispiel der vorliegenden Erfindung vorgesehen sein.

Der Komparator oder Verstärker 22 ist dazu ausgebildet,
- die am Knotenpunkt N' anliegende Spannung zu ermitteln,
- die ermittelte Spannung mit der durch die Referenzspannungsquelle 26 bereit gestellten Referenzspannung Vref zu vergleichen und
- im Bedarfsfalle die Spannung des Stützversorgungselements 34 dergestalt nachzuregeln oder zu steuern, insbesondere dergestalt anzuheben oder abzusenken, dass sich die Spannung am Knotenpunkt N' dem Wert der Referenzspannung Vref annähert.

Grundsätzlich kann die vorliegende Erfindung in vielfältiger Weise ausgestaltet werden; insbesondere durch Hinzufügen zusätzlicher Bauelemente oder zusätzlicher Bauteile in die Signal- und Regelpfade lässt sich die vorliegende Erfindung an bestimmte Erfordernisse anpassen.

Exemplarisch sei auf das optionale Widerstandselement 50 in Fig. 4C aufmerksam gemacht, das zur Verbindung des Stützversorgungselements 34 mit dem Gate-Anschluss G' des Transistors 30' genutzt werden kann, um durch induktives Anheben oder "Peaking" das Verhältnis der Steilheiten der fallenden Signalflanke gegenüber der steigenden Signalflanke zu verändern.

In diesem Zusammenhang sei darauf aufmerksam gemacht, dass der Begriff "Verbindung" im Rahmen der vorliegenden Erfindung auch Verbindungen oder Verbindungsarten umfasst, die durch zusätzlich eingebrachte Bauelemente oder Bauteile erfolgen.

### Bezugszeichenliste

- 100: Schaltungsanordnung, insbesondere Ansteuerschaltung oder Treiberschaltung (= vgl. Fig. 1)
- 100': Schaltungsanordnung, insbesondere Ansteuerschaltung oder Treiberschaltung (= vgl. Fig. 2)
- 100": Schaltungsanordnung, insbesondere Ansteuerschaltung oder Treiberschaltung (= vgl. Fig. 3)
- 100'": Schaltungsanordnung, insbesondere Ansteuerschaltung oder Treiberschaltung (=Ausführungsbeispiel der vorliegenden Erfindung; vgl. Fig. 4C und auch Figur 4A).

- 10: erstes Versorgungselement, insbesondere erste Spannungsquelle, beispielsweise erste Akkumulatoreinheit, zum Versorgen der Schaltungsanordnung 100, 100', 100", 100'" mit Spannung, insbesondere mit Gleichspannung
- 10': zweites Versorgungselement, insbesondere zweite Spannungsquelle, beispielsweise zweite Akkumulatoreinheit, zum Versorgen der Schaltungsanordnung 100, 100', 100", 100'" mit Spannung, insbesondere mit Gleichspannung
- 12: Stützkondensator, insbesondere kapazitive Stützung, des ersten Versorgungselements 10
- 12': Stützkondensator, insbesondere kapazitive Stützung, des zweiten Versorgungselements 10'
- 14: Versorgungsspannung, insbesondere Urspannung, des Versorgungselements 10, 10'
- 20: lichtemittierendes Bauelement, insbesondere elektrooptischer Wandler, beispielsweise lichtemittierende Diode (= L[ight]E[mitting]D[iode]) bzw. Leuchtdiode oder Laser, wie etwa Halbleiterlaser
- 22: Regelungs- und/oder Verarbeitungselement, insbesondere Komparator und/oder Verstärker, zum Beispiel Operationsverstärker
- 26: Bezugsspannungsquelle oder Referenzspannungsquelle
- 30: Schaltelement, insbesondere Einschalter oder Umschalter oder Wechselschalter, beispielsweise Schalttransistor, wie etwa M[etal]O[xide]S[emiconductor]F[ield]E[ffect]T[ransistor oder MOSTransistor, zum Beispiel n-Kanal-F[eld]E[ffekt]T[ransistor]
- 30': zweite Komponente des Schaltelements 30, insbesondere in Vorwärtsrichtung, insbesondere zum Schaltelement 30 hin, gepolte Diode, zum Beispiel pn-Diode oder Schottky-Diode und/oder Schalttransistor, beispielsweise M[etal]O[xide]S[emiconductor]F[ield]E[ffect]T[ransistor oder MOSTransistor, zum Beispiel n-Kanal-F[eld]E[ffekt]T[ransistor]
- 34: Stützversorgungselement, insbesondere Stützspannungsquelle, des Transistors 30'
- 40: Steuerungseinrichtung, insbesondere Signalquelle, des Transistors 30
- 50: Widerstand, insbesondere Ohmsches Widerstandselement
- C: Kondensator (= drittes Beispiel aus dem Stand der Technik; vgl. Fig. 5C)
- D: Drainanschluss des Transistors 30
- D': Drainanschluss des Transistors 30'
- E: lichtemittierendes Bauelement, insbesondere elektrooptischer Wandler, beispielsweise lichtemittierende Diode (= L[ight]E[mitting]D[iode]) bzw. Leuchtdiode oder Laser, wie etwa Halbleiterlaser (= Beispiele aus dem Stand der Technik; vgl. Fig. 5A, Fig. 5B, Fig. 5C)
- G: Gateanschluss des Transistors 30
- G': Gateanschluss des Transistors 30'
- K1: weitere Schaltungskomponente, nämlich Konstantstromquelle für I₁ (= Beispiele aus dem Stand der Technik; vgl. Fig. 5A, Fig. 5B, Fig. 5C)
- K2: zweite weitere Schaltungskomponente, nämlich Konstantstromquelle für I₂ (= Beispiele aus dem Stand der Technik; vgl. Fig. 5A, Fig. 5B, Fig. 5C)
- K2': dritte weitere Schaltungskomponente, nämlich Konstantstromquelle für I₂/2 (= drittes Beispiel aus dem Stand der Technik; vgl. Fig. 5C)
- L: Spule (= drittes Beispiel aus dem Stand der Technik; vgl. Fig. 5C)
- N: erster, insbesondere niederohmscher, Knoten oder Knotenpunkt zwischen erstem Versorgungselement 10, erstem Stützkondensator 12 und erster Schaltposition des Schaltelements 30
- N': zweiter, insbesondere niederohmscher, Knoten oder Knotenpunkt zwischen zweitem Versorgungselement 10, zweitem Stützkondensator 12 und zweiter Schaltposition des Schaltelements 30
- Q: Spannungsquelle, insbesondere Akkumulatoreinheit oder Akku (= Beispiele aus dem Stand der Technik; vgl. Fig. 5A, Fig. 5B, Fig. 5C)
- R: Blindlast (= erstes Beispiel aus dem Stand der Technik; vgl. Fig. 5A)
- S: Sourceanschluss des Transistors 30
- S': Sourceanschluss des Transistors 30'
- S1: Schaltungsanordnung (= erstes Beispiel aus dem Stand der Technik; vgl. Fig. 5A)
- S2: Schaltungsanordnung (= zweites Beispiel aus dem Stand der Technik; vgl. Fig. 5B)
- S3: Schaltungsanordnung (= drittes Beispiel aus dem Stand der Technik; vgl. Fig. 5C)
- T: Steuerungseinrichtung, insbesondere Signalquelle, zum Steuern (des Schaltens) des Schaltelements U, insbesondere Einschaltersteuerung oder Umschaltersteuerung oder Wechselschaltersteuerung (= Beispiele aus dem Stand der Technik; vgl. Fig. 5A, Fig. 5B, Fig. 5C)
- U: Schaltelement, insbesondere Einschalter oder Umschalter oder Wechselschalter (= Beispiele aus dem Stand der Technik; vgl. Fig. 5A, Fig. 5B, Fig. 5C)
- Vref: durch Bezugsspannungsquelle 26 bereit gestellte Bezugsspannung oder durch Referenzspannungsquelle 26 bereit gestellte Referenzspannung
- W: Bezugspotential oder Referenzpotential, insbesondere Erdpotential oder Massepotential oder Nullpotential

## Patentansprüche

1. Schaltungsanordnung (100"; 100"'), insbesondere Treiberschaltung, zum Ansteuern mindestens eines als mindestens eine lichtemittierende Diode oder Leuchtdiode oder als mindestens ein Halbleiterlaser ausgebildeten lichtemittierenden Bauelements (20), wobei die Schaltungsanordnung (100"; 100"') aufweist:
- mindestens zwei zum Versorgen der Schaltungsanordnung (100"; 100'") mit Spannung vorgesehene, parallel zueinander geschaltete, jeweils als ausgangsseitig kapazitiv, insbesondere mittels mindestens eines Stützkondensators (12; 12'), gestützte Stromquelle ausgebildete Versorgungselemente (10; 10'), die an mindestens eine Versorgungsspannung, insbesondere an mindestens eine Urspannung oder an mindestens eine Spannungsquelle (14), zum Beispiel an mindestens eine Batterie, angeschlossen und durch die Versorgungsspannung gespeist sind,
- mindestens ein den Ausgangsanschluss des ersten Versorgungselements (10) mit dem Eingangsanschluss des lichtemittierenden Bauelements (20) verbindendes, zumindest zwischen einer ersten Schaltposition und einer zweiten Schaltposition schaltbares Schaltelement (30) und
- mindestens ein zwischen mindestens eines der Versorgungselemente (10; 10') und das Schaltelement (30) geschalteter, nämlich den Ausgangsanschluss des zweiten Versorgungselements (10') mit dem Eingangsanschluss des lichtemittierenden Bauelements (20) verbindender Transistor (30'),
- dessen Drainanschluss (D') mit dem ersten Versorgungselement (10) oder mit dem zweiten Versorgungselement (10') verbunden ist,
- dessen Gateanschluss (G') mit mindestens einem Stützversorgungselement (34), insbesondere mit mindestens einer Stützspannungsquelle, verbunden ist und
- dessen Sourceanschluss (S') mit dem Eingangsanschluss des lichtemittierenden Bauelements (20) verbunden ist,
so dass das lichtemittierende Bauelement (20)
- in der ersten Schaltposition des Schaltelements (30) mit einer durch das erste Versorgungselement (10) bereit gestellten ersten Betriebsspannung beaufschlagbar ist,
- in der zweiten Schaltposition des Schaltelements (30) mit einer durch das zweite Versorgungselement (10) bereit gestellten zweiten Betriebsspannung beaufschlagbar ist und
- durch Umschalten zwischen der ersten Betriebsspannung und der zweiten Betriebsspannung ansteuerbar ist,
**gekennzeichnet durch** mindestens ein Regelungs- und/oder Verarbeitungselement (22), insbesondere durch mindestens einen Komparator und/oder durch mindestens einen Verstärker,
- dessen erster Eingangsanschluss mit dem zweiten Versorgungselement (10'), insbesondere mit der zweiten, ausgangsseitig kapazitiv gestützten Stromquelle, verbunden ist,
- dessen zweiter Eingangsanschluss mit mindestens einer Bezugsspannungsquelle oder Referenzspannungsquelle (26) verbunden ist und
- dessen Ausgangsanschluss mit dem Stützversorgungselement (34) verbunden ist.

2. Schaltungsanordnung gemäß Anspruch 1, **dadurch gekennzeichnet, dass** zwischen mindestens eines der Versorgungselemente (10; 10') und das Schaltelement (30) mindestens eine in Vorwärtsrichtung, insbesondere zum Schaltelement (30) hin, gepolte Diode (30'), zum Beispiel mindestens eine pn-Diode oder mindestens eine Schottky-Diode geschaltet ist.

3. Schaltungsanordnung gemäß Anspruch 1 oder 2, **dadurch gekennzeichnet, dass** das Schaltelement als mindestens zwei Transistoren (30 bzw. 30') ausgebildet ist,
- deren jeweiliger Drainanschluss (D bzw. D') mit dem ersten Versorgungselement (10) bzw. mit dem zweiten Versorgungselement (10') verbunden ist,
- deren Gateanschluss (G) mit mindestens einer Steuerungseinrichtung (40), insbesondere mit mindestens einer Signalquelle, bzw. deren Gateanschluss (G'), insbesondere über mindestens ein Widerstandselement (50), mit mindestens einem Stützversorgungselement (34), insbesondere mit mindestens einer Stützspannungsquelle, verbunden ist und
- deren jeweilige Sourceanschlüsse (S bzw. S') miteinander sowie mit dem Eingangsanschluss des lichtemittierenden Bauelements (20) verbunden sind.

4. Schaltungsanordnung gemäß mindestens einem der Ansprüche 1 bis 3, **dadurch gekennzeichnet, dass** der Transistor (30') bzw. die Transistoren (30; 30') als mindestens ein bzw. zwei M[etal]O[xide]S[emiconductor]F[ield]E[ffect]T[ransistor](s) oder als mindestens ein bzw. zwei MOS-Transistoren), insbesondere als mindestens ein bzw. zwei n-Kanal-F[eld]E[ffekt]T[ransistor](en), ausgebildet ist bzw. sind.

5. Verfahren zum Ansteuern mindestens eines als mindestens eine lichtemittierende Diode oder Leuchtdiode oder als mindestens ein Halbleiterlaser ausgebildeten lichtemittierenden Bauelements (20) durch Variieren seiner Betriebsspannung mittels mindestens einer Schaltungsanordnung (100"; 100'"), insbesondere mittels mindestens einer Treiberschaltung, gemäß mindestens einem der Ansprüche 1 bis 4,
wobei das lichtemittierende Bauelement (20)
- in der ersten Schaltposition des Schaltelements (30) mit einer ersten Betriebsspannung beaufschlagt wird,
- in der zweiten Schaltposition des Schaltelements (30) mit einer zweiten Betriebsspannung beaufschlagt wird und
- durch Umschalten zwischen der ersten Betriebsspannung und der zweiten Betriebsspannung angesteuert wird.

6. Verfahren gemäß Anspruch 5, **dadurch gekennzeichnet, dass** die Betriebsspannung des lichtemittierenden Bauelements (20) mittels Umschalten zwischen den Schaltpositionen, von denen zumindest die erste Schaltposition und die zweite Schaltposition für die Betriebsfrequenz niederimpedant sind, variiert wird.

7. Verwendung mindestens einer Schaltungsanordnung (100"; 100'"), insbesondere mindestens einer Treiberschaltung, gemäß mindestens einem der Ansprüche 1 bis 4 und/oder eines Verfahrens gemäß Anspruch 5 oder 6
- in mindestens einer, insbesondere mobilen, Telekommunikationsanlage, zum Beispiel in mindestens einem Kommunikationsgerät, wie etwa in mindestens einem Mobiltelefon,
- in mindestens einer, insbesondere mobilen, Datenkommunikationsanlage oder in mindestens einer, insbesondere mobilen, Datenverarbeitungseinrichtung, zum Beispiel in mindestens einem Handheld, in mindestens einem Notebook oder in mindestens einem P[ersonal]D[igital]A[ssistant],
- in mindestens einer, insbesondere mobilen, Datenaufzeichnungs- und/oder -wiedergabeeinrichtung, zum Beispiel in mindestens einem Camcorder, in mindestens einer Digitalkamera oder in mindestens einem H[igh]D[efinition]T[ele]V[ision], oder
- in mindestens einem Fortbewegungsmittel, zum Beispiel in mindestens einem Fahrerassistenzsystem oder in mindestens einem Navigationssystem eines Automobils.

## Claims

1. A circuit arrangement (100"; 100"'), in particular a driver circuit, for controlling at least one light-emitting component (20), embodied as at least one light-emitting diode or electroluminescent diode or as at least one semiconductor laser, wherein the circuit arrangement (100"; 100"') comprises:
- at least two supply elements (10; 10') connected to one another in parallel, each embodied as a current source capacitively, in particular by means of at least one decoupling capacitor (12; 12'), supported on the output side, said supply elements (10; 10') provided for supplying the circuit arrangement (100"; 100"') with voltage, said supply elements (10; 10') connected to at least one supply voltage, in particular to at least one Thevenin voltage or to at least one voltage source (14), for example to at least one battery, and fed by the supply voltage,
- at least one switching element (30) connecting the output terminal of the first supply element (10) to the input terminal of the light-emitting component (20) and switchable at least between a first switching position and a second switching position, and
- at least one transistor (30') connected between at least one of the supply elements (10; 10') and the switching element (30), namely connecting the output terminal of the second supply element (10') to the input terminal of the light-emitting component (20),
- the drain terminal (D') of said transistor (30') connected to the first supply element (10) or to the second supply element (10'),
- the gate terminal (G') of said transistor (30') connected to at least one supporting supply element (34), in particular to at least one supporting voltage source, and
- the source terminal (S') of said transistor (30') connected to the input terminal of the light-emitting component (20),
so that the light-emitting component (20)
-- is supplyable with a first operating voltage in the first switching position of the switching element (30), said first operating voltage provided by the first supply element (10),
-- is supplyable with a second operating voltage in the second switching position of the switching element (30), said second operating voltage provided by the second supply element (10'), and
-- is controllable by switching between the first operating voltage and the second operating voltage,
**characterized by** at least one regulating and/or processing element (22), in particular by at least one comparator and/or by at least one amplifier,
- the first input terminal of which is connected to the second supply element (10'), in particular to the second current source capacitively supported on the output side,
- the second input terminal of which is connected to at least one reference voltage source (26), and
- the output terminal of which is connected to the supporting supply element (34).

2. The circuit arrangement according to claim 1, **characterized in that** at least one diode (30') polarized in the forward direction, in particular towards the switching element (30), for example at least one pn diode or at least one Schottky diode, is connected between at least one of the supply elements (10; 10') and the switching element (30).

3. The circuit arrangement according to claim 1 or 2, **characterized in that** the switching element is embodied as at least two transistors (30 or 30'),
- the respective drain terminal (D or D') of which is connected to the first supply element (10) or to the second supply element (10'),
- the gate terminal (G) of which is connected to at least one control device (40), in particular to at least one signal source, or the gate terminal (G') of which connected, in particular via at least one resistance element (50), to at least one supporting supply element (34), in particular to at least one supporting voltage source, and
- the respective source terminals (S or S') of which are connected to one another as well as to the input terminal of the light-emitting component (20).

4. The circuit arrangement according to at least one of claims 1 to 3, **characterized in that** the transistor (30') is or the transistors (30; 30') are embodied as at least one or two M[etal]O[xide]S[emiconductor]F[ield]E[ffect]T[ransistor](s) or as at least one or two MOS transistor(s), in particular as at least one or two n-channel F[ield]E[ffect]T[ransistor](s).

5. A method for controlling at least one light-emitting component (20), embodied as at least one light-emitting diode or electroluminescent diode or as at least one semiconductor laser, by varying its operating voltage by means of at least one circuit arrangement (100"; 100'"), in particular by means of at least one driver circuit, according to at least one of claims 1 to 4,
wherein the light-emitting component (20)
-- is supplied with a first operating voltage in the first switching position of the switching element (30),
-- is supplied with a second operating voltage in the second switching position of the switching element (30), and
-- is controlled by switching between the first operating voltage and the second operating voltage,

6. The method according to claim 5, **characterized in that** the operating voltage of the light-emitting component (20) is varied by means of switching between the switching positions, of which at least the first switching position and the second switching position are of low impedance for the operating frequency.

7. Use of at least one circuit arrangement (100"; 100'"), in particular of at least one driver circuit, according to at least one of claims 1 to 4 and/or of a method according to claim 5 or 6
- in at least one, in particular mobile, telecommunication system, for example in at least one communication device, such as in at least one mobile telephone,
- in at least one, in particular mobile, data communication system or in at least one, in particular mobile, data processing device, for example in at least one handheld, in at least one notebook or in at least one P[ersonal]D[igital]A[ssistant],
- in at least one, in particular mobile, data recording and/or reproducing device, for example in at least one camcorder, in at least one digital camera or in at least one H[igh]D[efinition]T[ele]V[ision], or
- in at least one transportation means, for example in at least one driver assistance system or in at least one navigation system of an automobile.

## Revendications

1. Arrangement de circuit (100" ; 100"'), en particulier circuit de commande, pour commander au moins un composant émetteur de lumière (20), réalisé sous la forme d'au moins une diode émettrice de lumière ou diode électroluminescente ou sous la forme d'au moins un laser à semi-conducteur, l'arrangement de circuit (100" ; 100'") comportant :
- au moins deux éléments d'alimentation (10 ; 10') connectés en parallèle, chacun réalisé sous la forme d'une source de courant à support capacitif côté sortie, en particulier au moyen d'au moins un condensateur de découplage (12 ; 12'), lesdits éléments d'alimentation (10 ; 10') prévus pour l'alimentation en tension d'arrangement de circuit (100" ; 100"'), lesdits éléments d'alimentation (10 ; 10') connectés à au moins une tension d'alimentation, en particulier à au moins une tension de Thévenin ou à au moins une source de tension (14), par exemple à au moins une batterie, et alimentés par la tension d'alimentation,
- au moins un élément de commutation (30) reliant la borne de sortie du premier élément d'alimentation (10) à la borne d'entrée du composant émetteur de lumière (20) et pouvant être commuté au moins entre une première position de commutation et une deuxième position de commutation, et
- au moins un transistor (30') connecté entre au moins un des éléments d'alimentation (10 ; 10') et l'élément de commutation (30), c'est-à-dire reliant la borne de sortie du deuxième élément d'alimentation (10') à la borne d'entrée du composant émetteur de lumière (20),
- la borne de drainage (D') dudit transistor (30') connecté au premier élément d'alimentation (10) ou au deuxième élément d'alimentation (10'),
- la borne de grille (G') dudit transistor (30') connectée à au moins un élément d'alimentation de support (34), en particulier à au moins une source de tension de support, et
- la borne de source (S') dudit transistor (30') connectée à la borne d'entrée du composant émetteur de lumière (20),
de sorte que le composant émetteur de lumière (20)
-- puisse être alimenté avec une première tension de fonctionnement dans la première position de commutation de l'élément de commutation (30), ladite première tension de fonctionnement fournie par le premier élément d'alimentation (10),
-- puisse être alimenté avec une seconde tension de fonctionnement dans la seconde position de commutation de l'élément de commutation (30), ladite seconde tension de fonctionnement fournie par le second élément d'alimentation (10'), et
-- puisse être commandé par commutation entre la première tension de fonctionnement et la deuxième tension de fonctionnement,
**caractérisé par** au moins un élément de régulation et/ou de traitement (22), en particulier par au moins un comparateur et/ou par au moins un amplificateur,
- dont la première borne d'entrée est reliée au deuxième élément d'alimentation (10'), en particulier à la deuxième source de courant à support capacitif côté sortie,
- dont la deuxième borne d'entrée est connectée à au moins une source de tension de référence (26), et
- dont la borne de sortie est connectée à l'élément d'alimentation de support (34).

2. Arrangement de circuit selon la revendication 1, **caractérisé en ce que** au moins une diode (30') polarisée dans le sens direct, en particulier vers l'élément de commutation (30), par exemple au moins une diode pn ou au moins une diode Schottky, est connectée entre au moins un des éléments d'alimentation (10 ; 10') et l'élément de commutation (30).

3. Arrangement de circuit selon la revendication 1 ou 2, **caractérisé en ce que** l'élément de commutation est réalisé sous la forme d'au moins deux transistors (30 ou 30'),
- dont la borne de drainage respective (D ou D') est reliée au premier élément d'alimentation (10) ou au deuxième élément d'alimentation (10'),
- dont la borne de grille (G) est reliée à au moins un dispositif de commande (40), en particulier à au moins une source de signaux, ou dont la borne de grille (G') est reliée, en particulier par l'intermédiaire d'au moins un élément de résistance (50), à au moins un élément d'alimentation de support (34), en particulier à au moins une source de tension de support, et
- dont les bornes de source respectives (S ou S') sont reliées entre elles ainsi qu'à la borne d'entrée du composant émetteur de lumière (20).

4. Arrangement de circuit selon au moins l'une des revendications 1 à 3, **caractérisé en ce que** le transistor (30') est ou les transistors (30 ; 30') sont réalisé(s) sous la forme d'au moins un ou deux M[etal]O[xide]S[emiconductor]F[ield]E[ffect]T[ransistor](s) ou sous la forme d'au moins un ou deux MOS transistor(s), en particulier sous la forme d'au moins un ou deux F[ield]E[ffect]T[ransistor](s) à canal n.

5. Procédé pour commander au moins un composant émetteur de lumière (20), réalisé sous la forme d'au moins une diode émettrice de lumière ou diode électroluminescente ou sous la forme d'au moins un laser à semi-conducteur, en faisant varier sa tension de fonctionnement au moyen d'au moins un arrangement de circuit (100" ; 100"'), en particulier au moyen d'au moins un circuit de commande, selon au moins l'une des revendications 1 à 4,
où le composant émetteur de lumière (20)
-- est alimenté avec une première tension de fonctionnement dans la première position de commutation de l'élément de commutation (30),
-- est alimenté avec une seconde tension de fonctionnement dans la seconde position de commutation de l'élément de commutation (30), et
-- est commandé par commutation entre la première tension de fonctionnement et la deuxième tension de fonctionnement.

6. Procédé selon la revendication 5, **caractérisé en ce que** la tension de fonctionnement du composant émetteur de lumière (20) est variée par commutation entre les positions de commutation, dont au moins la première position de commutation et la deuxième position de commutation sont de faible impédance pour la fréquence de fonctionnement.

7. Utilisation d'au moins un arrangement de circuit (100" ; 100"'), en particulier d'au moins un circuit de commande, selon l'une des revendications 1 à 4 et/ou d'un procédé selon la revendication 5 ou 6
- dans au moins un système de télécommunication, en particulier mobile, par exemple dans au moins un appareil de communication, comme dans au moins un téléphone portable,
- dans au moins un système de communication de données, en particulier mobile, ou dans au moins un dispositif de traitement de données, en particulier mobile, par exemple dans au moins un appareil portatif, dans au moins un notebook ou dans au moins un assistant numérique personnel (P[ersonal]D[igital]A[ssistant]),
- dans au moins un dispositif d'enregistrement et/ou de reproduction de données, en particulier mobile, par exemple dans au moins un caméscope, dans au moins une caméra numérique ou dans au moins une télévision haute définition (H[igh]D[efinition]T[ele]V[ision]), ou
- dans au moins un moyen de déplacement, par exemple dans au moins un système d'assistance à la conduite ou dans au moins un système de navigation d'une automobile.
